# EUROPEAN PATENT APPLICATION

(11) **EP 4 236 241 A1**
(43) Date of publication of application: **30.08.2023**
(21) Application number: 23154116.0
(22) Date of filing: 31.01.2023
(51) Int. Cl.: H04L 41/147, H04L 41/16, H04W 4/30, H04W 24/00

(54) **A METHOD, AN APPARATUS AND A COMPUTER PROGRAM PRODUCT FOR NETWORK PERFORMANCE DETERMINATION**

(30) Priority: 23.02.2022 FI 20225164
(71) Applicant: Nokia Solutions and Networks Oy, 02610 Espoo (FI)
(72) Inventor: ERMAN, Bilgehan, Weehawken, NJ 07086 (US); DI MARTINO, Catello, 38406-632 Uberlandia (BR)
(74) Representative: Nokia EPO representatives

(57) **Abstract**

The embodiments relate to a method, comprising transforming a physical environment into a three-dimensional (3D) digital representation; mapping the 3D digital representation to a feature vector representation to generate a set of features; determining a performance of a wireless network at the physical environment; enabling a machine learning algorithm to learn mapping between the determined performance and the generated set of features; generating a virtual layout of the environment; and generating performance prediction by means of the machine learning algorithm inferring a performance corresponding to the generated virtual layout. The embodiments also relate to technical equipment for implementing the method.

## Description

### Technical Field

The present solution generally relates to a method and technical equipment for determining performance of a wireless network.

### Background

The fifth generation (5G) technology standard for broadband cellular networks is designed to connect billions of devices, thus enabling Internet of Things (IoT), i.e., a communication from machine to machine. 5G provides a unique opportunity to distribute processing nodes such that computing is available nearest to the point of use.

In addition to the mobile operator networks, 5G networks can be utilized for various private networks, for example, industrial loT and enterprise networking. Uninterrupted and high-quality data communication is one of the most important prerequisites for implementing private wireless 5G network for industrial automation. One of the challenges in 5G-enabled industry is that in industrial facilities, the quality network connections can be hard to come because stability of a wireless network can be undermined by industrial machines, moving parts, changes in the factory floor layout, goods stored on pallets and stockpiled inventory obstructing wireless signals.

### Summary

The present embodiments provide a solution to predict a network performance of a wireless network. The scope of protection sought for various embodiments of the invention is set out by the independent claims. The embodiments and features, if any, described in this specification that do not fall under the scope of the independent claims are to be interpreted as examples useful for understanding various embodiments of the invention.

Various aspects include a method, an apparatus and a computer readable medium comprising a computer program stored therein, which are characterized by what is stated in the independent claims. Various embodiments are disclosed in the dependent claims.

According to a first aspect, there is provided an apparatus comprising means for transforming a physical environment into a three-dimensional (3D) digital representation; means for mapping the 3D digital representation to a feature vector representation to generate a set of features; means for determining a performance of a wireless network at the physical environment; means for enabling a machine learning algorithm to learn mapping between the determined performance and the generated set of features; means for generating a virtual layout of the environment; and means for generating performance prediction by means of the machine learning algorithm inferring a performance corresponding to the generated virtual layout.

According to a second aspect, there is provided a method, comprising: transforming a physical environment into a three-dimensional (3D) digital representation; mapping the 3D digital representation to a feature vector representation to generate a set of features; determining a performance of a wireless network at the physical environment; enabling a machine learning algorithm to learn mapping between the determined performance and the generated set of features; generating a virtual layout of the environment; and generating performance prediction by means of the machine learning algorithm inferring a performance corresponding to the generated virtual layout.

According to a third aspect, there is provided an apparatus comprising at least one processor, memory including computer program code, the memory and the computer program code configured to, with the at least one processor, cause the apparatus to perform at least the following: transform a physical environment into a three-dimensional (3D) digital representation; map the 3D digital representation to a feature vector representation to generate a set of features; determine a performance of a wireless network at the physical environment; enable a machine learning algorithm to learn mapping between the determined performance and the generated set of features; generate a virtual layout of the environment; and generate performance prediction by means of the machine learning algorithm inferring a performance corresponding to the generated virtual layout.

According to a fourth aspect, there is provided computer program product comprising computer program code configured to, when executed on at least one processor, cause an apparatus or a system to: transform a physical environment into a three-dimensional (3D) digital representation; map the 3D digital representation to a feature vector representation to generate a set of features; determine a performance of a wireless network at the physical environment; enable a machine learning algorithm to learn mapping between the determined performance and the generated set of features; generate a virtual layout of the environment; and generate performance prediction by means of the machine learning algorithm inferring a performance corresponding to the generated virtual layout.

According to an embodiment, the 3D digital representation is processed to identify objects at desired level of granularity, wherein the objects are used to generate a set of features.

According to an embodiment, the virtual industrial layout is generated by using Generative Adversarial Network.

According to an embodiment, physical properties of the physical environment are captured, based on which the transformation into the digital representation is performed.

According to an embodiment, object recognition is performed on captured physical properties.

According to an embodiment, the physical environment is an industrial environment.

According to an embodiment, the computer program product is embodied on a non-transitory computer readable medium.

### Description of the Drawings

In the following, various embodiments will be described in more detail with reference to the appended drawings, in which
- Fig. 1: shows a diagram on a time spent on various activities for 5G network validation testing;
- Fig. 2: shows examples of high-level KPIs;
- Fig. 3: shows an example of an environment discovery, mapping to feature vector;
- Fig. 4: shows an example of an advanced environment discovery generating detailed representation of the environment;
- Fig. 5: shows an example of learning the environment to performance profile mapping;
- Fig. 6: shows an example of performance predictions for new environments;
- Fig. 7: shows an example of performance prediction workflow;
- Fig. 8: shows an example of a workflow for what-if trials;
- Fig. 9: shows another example of the workflow for what-if trials;
- Fig. 10: is a flowchart illustrating a method according to an embodiment; and
- Fig. 11: shows an apparatus according to an embodiment.

### Description of Example Embodiments

The following description and drawings are illustrative and are not to be construed as unnecessarily limiting. The specific details are provided for a thorough understanding of the disclosure. However, in certain instances, well-known or conventional details are not described in order to avoid obscuring the description. References to one or an embodiment in the present disclosure can be, but not necessarily are, reference to the same embodiment and such references mean at least one of the embodiments.

Reference in this specification to "one embodiment" or "an embodiment" means that a particular feature, structure, or characteristic described in connection with the embodiment in included in at least one embodiment of the disclosure.

The present embodiments relate to 5G (fifth-generation) networks for industrial automation. In addition to the 5G networks, the present embodiments are applicable with other wireless technologies, such as 6G (and other subsequent generations) or WiFi 6 (also known as AX WiFi ja 802.11ax WiFi) (and other future versions). For implementing such Operation Technology (OT) -grade private wireless network, uninterrupted and high-quality data communication is one of the most important prerequisites. The objective in 5G-enabled industry is to make every part of the production environment: i) fluid, i.e. capable of operating in any corner of the facility with predetermined, predictable and guaranteed service levels, and ii) enhanced, by moving intelligence, analytics, control and optimization algorithms from local device to the edge cloud. The final objective is to enable factory owners (for Al-driven algorithms) to continuously adapt the production lines to address market demands and business goals.

As discussed in the background section, one of the main challenges in 5G-enabled industry is that in industrial facilities, such as warehouses and factories, the quality network connections can be hard to come by not only because cabling for a wired network takes strenuous efforts, but also because the stability of a wireless network can be undermined by industrial machines, moving parts, changes in the factory floor layout, goods stored on pallets, and stockpiled inventory obstructing wireless signals. This, jointly with the high rates of reconfiguration and mobility of modern industrial verticals (e.g., factories, airports, and logistics), complicates the mission-critical role of the private 5G network that must be able to enable wireless operations 24/7 (twenty-four hours per day/seven days per week) anywhere in the covered are with given network service level agreements (SLA), e.g., bandwidth and latency requirements that are use-case specific. Mutating business goals, use cases and production environment changes of layout translates in a call for a fundamental transformation in how new network capabilities are developed, deployed, and maintained, through new levels of network agility, flexibility and automation. While IT and web scale companies embraced different development approaches to enable continuous delivery and continuous testing in production to adapt the changing business goals and system configurations (e.g., DevOps), industrial networks are still planned, designed and delivered following a conventional and inflexible linear flow (the waterfall approach).

Besides the continuous testing of the mission-critical wireless networks - provided by platforms such as an Autonomous Factory 5G SLA Testing (F5GT) platform - there is a strong need for a capability to predict at the design phase what the performance of a mission-critical network would be when deployed. The more accurate the performance predictions are, the lower the cost of deployment will be (by elimination of changes and reconfigurations).

There are several open problems in designing, delivering, exercising and maintaining private wireless networks for industrial automations, as described in the following:

### Network design

The first step in designing a network for industrial automation is the site survey. This step includes an analysis of the site (e.g., a factory floor) layout, position of obstructions (e.g., metals and concrete structures), and collection of the use case description. The output of this phase is the creation of a model for the radio planning of the network what will identify the type, model, power, position, and orientation of the needed antennas. This phase is strictly dependent on
1) current layout of the factory at the time of the survey;
2) current description of the use case scenario at the time of the survey;
3) current configuration of the obstructions (e.g., pallets, metals, etc.) at the time of the survey

The problem in this approach is that there is no way to trace how a single change in any of the mentioned items impact the capability of the network to fulfil the requirements of a specific use case (e.g., coverage, latency and bandwidth). This problem impacts the effectiveness of private wireless solutions to changing environments and changing use cases.

### Network delivery and validation

The current process in validating a private network for industrial automation is inherited from testing and deploying mobile networks for CSPs (Communication Service Providers), where specific features of the network are gradually introduced in the production network and tested with drive-in tests, after an initial lab testing time or First Office Application window in a controlled environment. The drive-in tests involve several engineers running specific measurement and tests (e.g., throughput analysis) using a laptop while moving between different sites of the area covered by the radio network under test. Tests may have been designed to reproduces call and data performance in mobility use cases (e.g., highway, city centers, tunnels, etc.) mimicking end users connected to the cellular network using smartphones. Usually, GPS data is used to build network capability maps and to pinpoint problematic areas. A team of several performance specialists may be involved in the process.

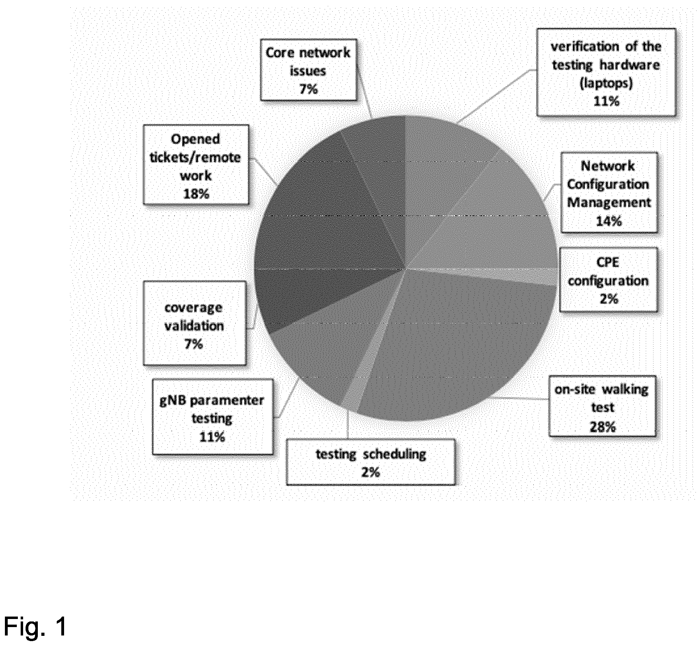

5G networks currently adopt a similar process. After in-lab testing, the network is deployed in the industrial environment. Depending on the size of the site, one or more engineers perform walking tests of the factory using a cart equipped with a laptop, a 5G CPE/modem (Customer Premises Equipment) and a UPS (Uninterruptible Power Supply) battery pack to power the equipment. The lack of GPS (Global Positioning System) data on speed and position, lack of automation, coordination, storage, and equipment debugging tools, make this process cumbersome, expensive and time consuming, as the performance specialist must physically walk the entire covered area while performing manual tests. Several complete walk tests may be needed for each of the use cases. In addition, the factory may be reconfigured and/or different shift (e.g., nightly, and daily) can involve the usage of different equipment that may impact the network performance. Figure 1 shows an example of the principal causes of delays of the 5G network testing process.

The causes of delays being shown in Figure 1 have been collected across several manufacturing and logistics use case. As indicated in the chart, the time spent physically walking in the factory is 28% of the overall testing time, which together with the time spent solving network configuration issues (e.g., for each test and use case), validating the testing hardware, radio coverage validation, and testing of the parameters of the radio interface, total more than 71% of the total testing time. Even after in-depth walk testing of the network, many problems remain unsolved. For instance, additional time is spent, for instance, to provide context for and troubleshoot network configuration problems that need to be escalated to other teams. The mentioned problems and high cost make this type of network testing unsuitable to run continuously, or automatically, for instance, after each change of the factory floor layout which can take place on a week to months timescales.

Continuous testing and monitoring relay on real-time test execution and data processing to continuously provide a feedback on specific network features throughout all stages of the network life cycle, such as requirements planning, development and directly from the factory floor during acceptance testing and operations. This enables providing higher-value service to the network user (e.g., the factory), such as dynamic network reconfiguration for faster response times and lower total cost of ownership of the network. Continuous testing provides immediate and continuous feedback on every network and factory floor configuration. However, automated testing and feedback require a common end-to-end test strategy that is reproducible.

### Changes in the use case requirements

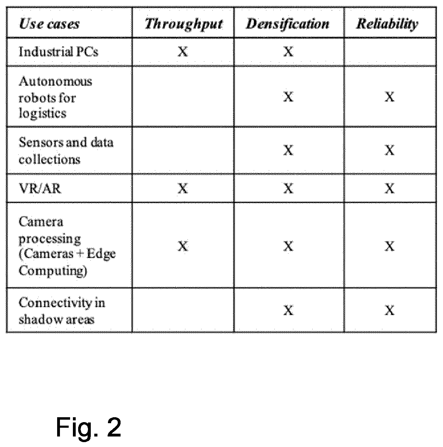

After the deployment of a 5G network solution in an industrial environment, the network is tested for different aspects, which may be dependent on the use cases and vertical segment requirements. An example of high-level KPIs (Key Performance Indicators) is illustrated in Figure 2. Example SLAs for each use case may be expressed in terms of latency, bandwidth, and reliability. Network acceptance is related to evaluating the KPIs for a period, even though different acceptance criteria can be adopted. For instance, for Autonomous Robot, a compound SLA definition can better represent the network capabilities instead of single KPI threshold: *"Latency < 20ms for 99.99% of the packets, packet drop rate < 0.001%, bandwidth > 20Mbitls 99.99% of mission time".*

The problem is that when the use case requirements change, changes in the network configuration might be required to accommodate the network SLAs. To address the problem, the first task is to use a systematic approach to test and measure the network capabilities for the specific use case before and after the change needed. In this perspective, it is clear that: i) measurements and tests must be executed in a reproducible and systematic way to enable comparison across different use cases, ii) test results are based on observing factors that are mutually influencing each other (e.g., used network throughput vs. end-to-end latency for the latency test and number of connected devices vs. throughput and latency for densification). In addition, given the variety of use cases and requirements (e.g., in terms of latency and bandwidth), performing the mere throughput and latency test might not reflect the actual capability of the network to meet the specific use case SLA. However, today there is no standardized way of performing tests, resulting in inconsistent results that in the best case provide only a partial view of how the applied change to the network changed the capability of fulfilling the requirements of a specific use case.

### Troubleshooting and maintenance

Current approach for troubleshooting private network are somehow a direct reflection of the experience with Mobile Network Operators (MNO) with public networks. However, there are two important distinctions to highlight:
1) For MNO, the maintenance of the network is planned according to specific maintenance window (usually at the nights), and usually the impact of the network availability is minimized given the redundancy/overall of network sites covering the same region. The maintenance of private wireless networks for factory automation should be planned according to the factory schedule, and performed automatically as much as possible. Most of the time remote connection is not possible due to privacy issues and specialized personnel has to be sent on site. In addition, the level of redundancy of a factory network is not sufficient to allow upgrading/changing the network without a substantial offline period. Configuration may be chosen on a case-by-case fashion considering the specific use case requirements.
2) For MNO, the troubleshooting may be triggered when a statistically significative number of users or KPI values are experiencing something different from expected. This is quantified looking at aggregated statistics at the core level as described below. This task may be performed automatically and continuously in the network by collecting Performance Management (PM) and Fault Management (FM) data from the network core. Data is aggregated at core level (not at User Equipment (UE) level) on interval spanning several minutes. For instance, the core network monitoring allows analysis of the throughput of the network core as aggregated statistics computed each 15min. Usually the core network monitoring includes collection of several hundreds of 3GPP (3rd Generation Partnership Project) KPIs used to compute metrics like cell availability and 5G retainability. An evolution of this approach is the per-call measurement data (PCMD) technique that provides selected call measurement data on a per-procedure basis for most of the procedure interactions that the user has in the 4G and 5G network. PCMD provides a view of the user experience in 4G and 5G networks. PCMD collects data associated with the connection, i.e., records are generated when an LTE/5G (Long Term Evolution/5G) procedure (e.g., hand-off, connect, etc.) ends either successfully or unsuccessfully. It provides a way to view network data on a per-procedure, per-user basis. While this approach is very successful for MNO, it does not perform well for private wireless for industrial automation since i) the equipment is usually statically connected, e.g., the PCMD record would not be created unless periodically done or when the device disconnects from the network or the hand-off is performed, ii) requires post-processing as PCMD records are usually designed for offline analysis while in the industrial automation there is a need for real-time continuous monitoring and network testing, and iii) requires specific features to be enables in the network elements, such as PCMD services on the network controller, MME (Mobility Manager Entity) or eNB/gNB (evolved Node B/next generation Node B) elements; such features are usually not available for industrial wireless as they require different setup flavors (e.g., MNO networks, GPS positioning system on each device, and a large number of UEs connected).

However, these types of testing solutions do not necessarily have components to assist the planning and the design of industrial wireless networks or to provide guidance for modifying existing network configurations. To assist the design and reconfiguration process (of both the industrial setting and the wireless network), it is desirable to have the capability to predict how a particular requirements of the use case and a particular aspect of the factory floor would perform with a given network design before through the costly deployment and validation process.

Applications in industrial automation systems have stringent requirements regarding latency and reliability. Key important use cases with their varying demands on the communications network have been prioritized and known.

Network resilience is the ability of a network to maintain an acceptable level of service in the face of faults and changes to normal operation. Despite the bulk of the work in the scientific literature on network resilience, the research on how to create continuous testing for industrial private wireless (LTE, 5G and beyond) can be considered still at its early stages.

In the last decade, there have been two major paradigm shifts that challenge traditional network development and delivery methodologies, i.e., the cloudification of products that traditionally used to come as a hardware appliance, and the expectation from customer that fixes and features must be made available within a short time frame, e.g., weeks as opposed to a few months. Agile development and DevOps methodologies have been utilized to address this requirement. But for these practices to work, the testing environment must be very flexible, one that allows for continuous delivery, continuous integration, and continuous testing to take place. Specifically, for continuous testing the requirement is to allow for automated execution of test cases, for several different releases in parallel, employing multiple testbeds, by different teams.

Although the virtualized IP (Internet Protocol) testing market is a multimillion-dollar market with exponential growth, the specific offerings have been developed for manual and point testing. More importantly, no platform includes a Testing-as-a-service approach with possibility to integrate the testing process into the everyday's operation of the factory, therefore addressing the continuous testing requirements.

Finally, no available platform includes the concept of SLA management and SLA capability map, both crucial to ensure continuous delivery of OT-level communication in industrial environment.

In order to improve the technology with respect to 5G network performance, the present embodiments provide a platform to provide a digital twin of industrial 5G networks. The platform is referred here as Generative Network Performance Prediction (GNPP).

The embodiments utilize deep neural networks. Before describing the present embodiments in more detailed manner, a short reference to neural networks is given. Neural network is a computation graphs consisting of several layers of computation. Each layer of a neural network consists of one or more units, where each unit performs an elementary computation. A unit is connected to one or more other units, and the connection may have associated with a weight. The weight may be used for scaling the signal passing through the associated connection. Weights are learnable parameters, i.e., values which can be learned from training data. There may be other learnable parameters, such as those of batch-normalization layers.

Two of the most widely used architectures for neural networks are feed-forward and recurrent architectures. Feed-forward neural networks are such that there is no feedback loop: each layer takes input from one or more of the layers before and provides its output as the input for one or more of the subsequent layers. Also, units inside a certain layer take input from units in one or more of preceding layers and provide output to one or more of following layers.

Initial layers (those close to the input data) extract semantically low-level features and final layers extract more high-level features. After the feature extraction layers there may be one or more layers performing a certain task, such as classification, semantic segmentation, object detection, denoising, style transfer, super-resolution, etc. In recurrent neural nets, there is a feedback loop, so that the network becomes stateful, i.e., it is able to memorize information or a state.

One of the important properties of neural networks (and other machine learning tools) is that they are able to learn properties from input data, either in supervised way or in unsupervised way. Such learning is a result of a training algorithm, or of a meta-level neural network providing the training signal.

In general, the training algorithm consists of changing some properties of the neural network so that its output is as close as possible to a desired output. For example, in the case of classification of objects in images, the output of the neural network can be used to derive a class or category index which indicates the class or category that the object in the input image belongs to. Training usually happens by minimizing or decreasing the output's error, also referred to as the loss. Examples of losses are mean squared error, cross-entropy, etc. In recent deep learning techniques, training is an iterative process, where at each iteration the algorithm modifies the weights of the neural net to make a gradual improvement of the network's output, i.e., to gradually decrease the loss.

Training a neural network is an optimization process. The goal of the optimization or training process is to make the model learn the properties of the data distribution from a limited training dataset. In other words, the goal is to learn to use a limited training dataset in order to learn to generalize to previously unseen data, i.e., data which was not used for training the model. This is usually referred to as generalization. In practice, data may be split into at least two sets, the training set and the validation set. The training set is used for training the network, i.e., to modify its learnable parameters in order to minimize the loss. The validation set is used for checking the performance of the network on data, which was not used to minimize the loss, as an indication of the final performance of the model. In particular, the errors on the training set and on the validation set are monitored during the training process to understand the following things:
- If the network is learning at all - in this case, the training set error should decrease, otherwise the model is in the regime of underfitting.
- If the network is learning to generalize - in this case, also the validation set error needs to decrease and to be not too much higher than the training set error. If the training set error is low, but the validation set error is much higher than the training set error, or it does not decrease, or it even increases, the model is in the regime of overfitting. This means that the model has just memorized the training set's properties and performs well only on that set but performs poorly on a set not used for tuning its parameters.

The platform, according to present embodiments, is designed to provide an automated control, orchestration, data collection and intelligence in the network to enable continuous learning of how the network performs under the specific factory settings and use case requirements. The digital twin refers to a model that is created of the factory and the network based on the collected data to identify how a change in a single parameter (e.g., presence of metals or use case requirements) might change the capability of the network to fulfill a specific use case or a SLA (Service Level Agreement).

The platform comprises
- a number of core services for test scheduling, orchestration, SLA management, data collection, anomaly detection and for creating advanced data-driven automations and pipelines, and
- an embedded hardware that acts as a CPE and local data probe in the industrial area, with ready to use interfaces to state of the art AGV platforms and industrial protocols (e.g., RTU Modbus (Remote Terminal Unit ).

An example of the process to create a digital twin of the platform comprises a series of steps 1 - 3 that allow prediction of wireless network performance for a given industrial layout. It is appreciated that in this disclosure term "environment" refers to target industrial settings such as autonomous factory layouts. The steps are:
1) Learning the correlation between an industrial layout and the corresponding wireless network performance from empirical data;
2) Generating new, virtual industrial layouts;
3) Generating performance predictions for the generated, new industrial layouts.

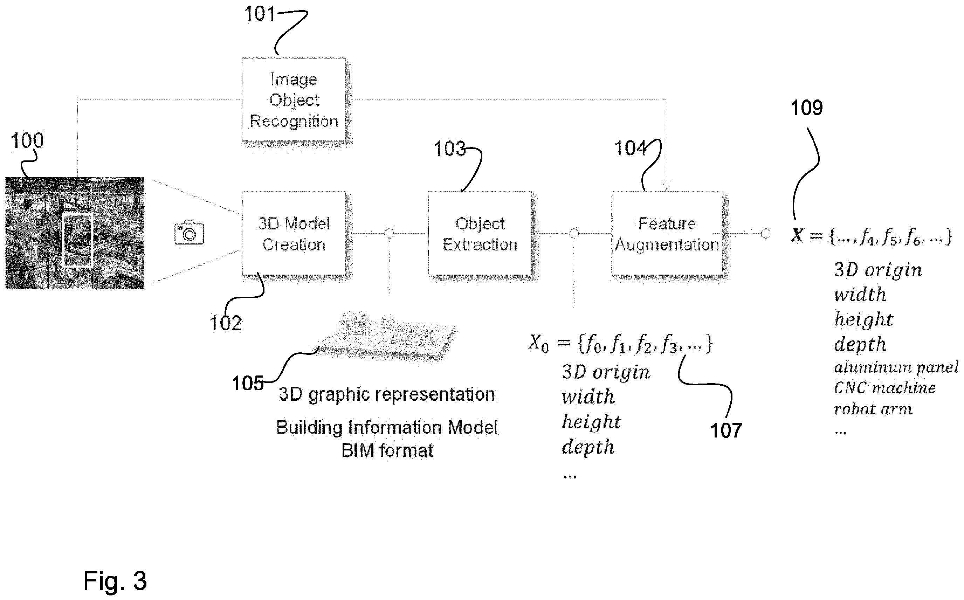

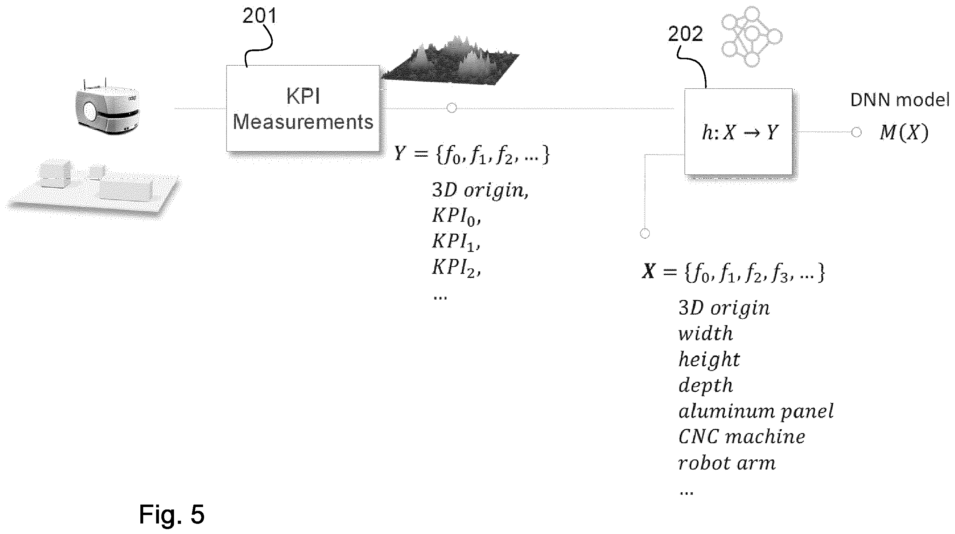

The first step 1), i.e., the learning of the mapping between the industrial layout and the performance profile, may be achieved by doing:
a) Environment discovery to transform the physical environment to its digital representation, as illustrated in an example of Figure 3;
b) Mapping of digital representation to a feature vector representation, as illustrates in an example of Figure 3;
c) Deep neural network training to learn the correlation of the layout to wireless network performance, as illustrates in an example of Figure 5.

Wireless network performance profiles for specific environments are created by the FT (Factory Testing) platform as mentioned in the previous sections. It is to be noticed that this step is out of the scope of the present embodiments.

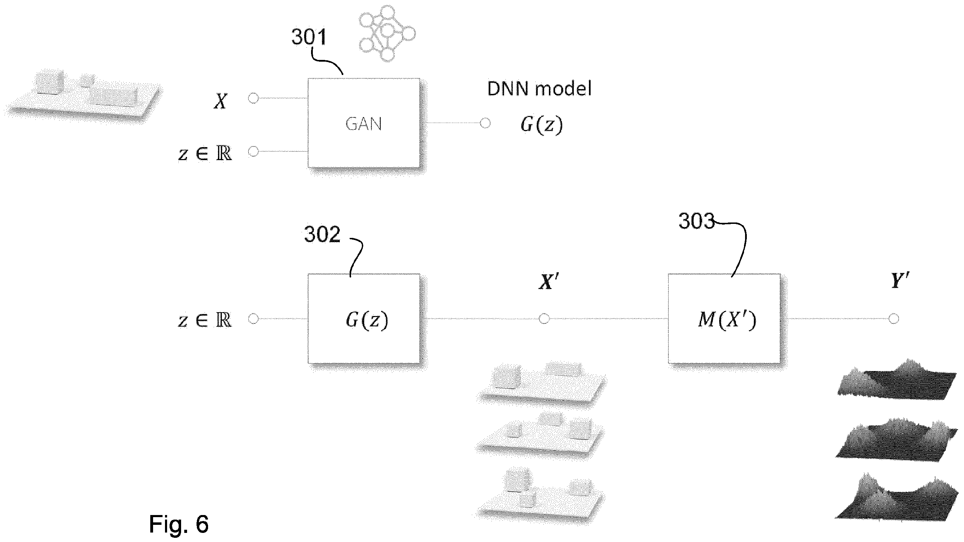

The second step 2), i.e., the creation of new, virtual industrial layouts is achieved by using a class of neural network architecture called Generative Adversarial Network (GAN), as illustrated in an example of Figure 6.

The last step 3), i.e., the creation of wireless network performance predictions for new industrial layouts of modified industrial layouts is achieved by using a deep neural network model to infer the wireless network performance profiles that would correspond to new industrial layouts. The model used in this step is the one created in step c) above and shown in example of Figure 5.

Three groups of high-level procedures 1 - 3 being described above and having the end goal of predicting how a mission-critical wireless network would perform in new industrial layout, are discussed next in further detailed manner.

In order to carry out the step 1) i.e. learning the correlation between an industrial layout and the corresponding wireless network performance from empirical data, the following workflow may be applied. The workflow is illustrates in Figure 3 as an example. The workflow comprises at least:
- Image object recognition 101;
- 3D model creation 102;
- Object extractor 103;
- Feature augmentation 104.

The process starts by capturing 100 the physical properties of the environment (such as width, height) using video camera, photographic camera, a laser scanner (LiDAR, Light Detection and ranging), or by other technique providing the same. The image object recognition 101 captures categorical properties of the objects in the environment (such as robot arm, aluminum panel) by using visual computing and image recognition techniques. The information of each object may include the type of the object (regarding the context of the industrial setting), and referential information to associate the object to the environmental layout - for example, the camera position, the camera angle, and distance to the object. For *M_{img}* number of objects, and for *N_{img}* number or properties, the output would then be an *M_{img}N_{img}* matrix. A 3D model 102 of the target environment is generated using the captured details.

The 3D model generation 102 and the image object recognition 101 are well-known techniques in the industry, and therefore the procedural details of the these steps are not discussed further in this disclosure.

Next, a 3D graphical model 105 is generated at 3D model creation 102. There are many different formats in the industry for the 3D graphical models. One of the formats is the "Building Information Modelling" (BIM). However, although BIM at this point can be considered one of the most capable formats in terms of representing rich object properties, simpler and more widely used 3D graphics file formats such as STL (Standard Triangle Language), OBJ (Object), or DAE (Digital Asset Exchange) may be used instead. The choice of the file format may depend on the availability of 3D graphical software that would be used to process the content.

The object extraction 103 processes the 3D graphical representation 105 of the environment to identify objects at desired level of granularity. For example, when the 3D model represents objects at 1cm granularity with screws and rivets, the object extraction function instead may identify grouping of objects at 2-, 3- meter granularity, such as a whole CNC (Computerized Numerical Control) machine or a robot arm. Procedural steps of this functional steps is straightforward in terms of applying grouping and clustering techniques, but the specifics of the procedure will depend on the detailed characteristics of the 3D graphical model - for example, the 3D model creation 102 may already generate a very rich representation with hierarchical grouping of objects, which would make the object extraction 103 quite trivial; or it may just list thousands of small objects with no meaningful containment relationships, which would make the task of the object extraction 103 quite complicated.

The object extraction 103 is configured to create a list 107 of features for each identified object. These features will be items such as x, y coordinates, width, height, and depth of the object. For *M_{obj}* objects, and for *N_{obj}* features, the output is an *M_{obj}N_{obj}* matrix.

Feature augmentation 104 brings together the outputs from Image object recognition 101 and Object extraction 103. Using the locational associations between the two data sources, the function Feature augmentation builds the *X* data set 109, which is an *MN* matrix, where *M* is the number of objects from the Object extraction 103, and *N* is the union of *N_{obj}* features from Object extraction 103 and subset of properties from the Image object recognition 101. Being "a subset" is because once the object associations are built, the properties, such as camera position and angle is not useful for the rest of the workflow. Therefore, the output from the Feature augmentation 104 will be an *MN* matrix . (*M_{obj}* is selected for the number of objects, because even if the number of objects from the Image object recognition 101 is larger, it will be of no interest if there isn't a corresponding object representation in the output of the Object extraction 103 block.)

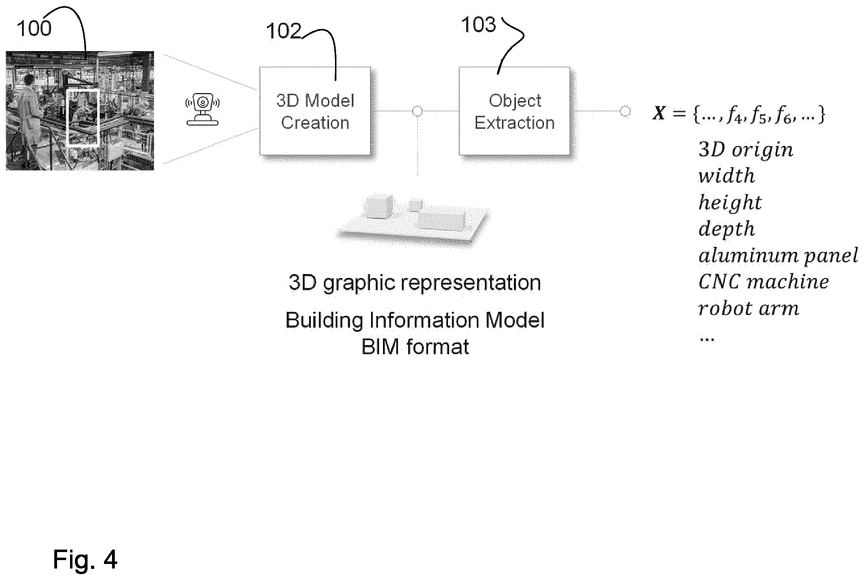

It should be noticed that - as shown in Figure 4 - a highly advanced commercial service my provide a very detailed BIM model for the environment with all the relevant properties of all objects at different hierarchical grouping levels (3D model creation 102), which would eliminate the need for the object recognition 101 and feature augmentation 104 of Figure 3, while also making the task of object extraction 103 quite trivial to implement.

A procedural workflow for mapping of digital representation to a feature vector representation (b) of step 1) comprises the following steps, as illustrated in Figure 5 as an example:
- KPI measurements 201;
- Neural network 202

KPI measurements 201 represents the exiting work that is referred to as F5GT as explained earlier. The output of KPI measurements 201 is Y, which is an *MₖₚᵢNₖₚᵢ* matrix, where *Mₖₚᵢ* is the number of performance measurement samples, and *Nₖₚᵢ* is the set of features that include measurement coordinates within the environment and a set of KPI measurements. *Mₖₚᵢ* is expected to be much larger than *M* in the output of the Feature Augmentation block (because there will be many performance measurements around each single object).

The neural network 202 learns the mapping *h* between the dataset *X* and the dataset *Y.* It learns the association between a given instance of *X* and a corresponding approximation of an instance of *Y*. The learned mapping is captured as the parametric model of the neural network, *M(X).*

A procedural workflow for creation of new, virtual industrial layouts (step 2 above) comprises the following steps, as illustrated in Figure 6 as an example:
- Generative Adversarial Network (GAN) 301;
- G(z) 302;
- M(X') 303

GAN 301 refers to Generative Adversarial Network where a training phase is implemented between a generator (G) and a discriminator (D). Both the generator and the discriminator may be neural networks. The generator G has the goal of generating realistic-looking data. The discriminator (D) sometimes gets as an input "fake" data generated from the generator, and sometimes real data from a dataset. The goal of the discriminator is to correctly discriminate when the input is fake or real. In the present embodiments, GAN 301 learns to generate new *Xs* as *X'*. For example, it is configured to generate new, unseen factory floor layouts together with associated object properties which are just like existing, real factory floors. If the performance of GAN is very high, a person wouldn't be able to tell if the X' is human designed or not.

The output of the GAN block is *G(z)* 302, which is the parametric model of the GAN's neural network.

Although the performance of GANs is still an active research area, the basic implementation of the technique is well understood in the industry. Therefore, the procedural details of how the GAN technique is applied will not be in the scope of the present disclosure.

G(z) 302 is the application of the learned GAN model for generating new environments. The output of the block X', is an MN matrix representing the objects and the features of a new environment with similar characteristics as the real environments, but with a unique layout instantiation.

The last step 3), i.e., the creation of wireless network performance predictions for new industrial layouts of modified industrial layouts is achieved by using a deep neural network model to infer the wireless network performance profiles that would correspond to new industrial layouts. Thus, M(X') 303 of Figure 5 represents application of the neural network model 202. When the input is X', the output will be Y', which will be the predicted wireless network performance profile.

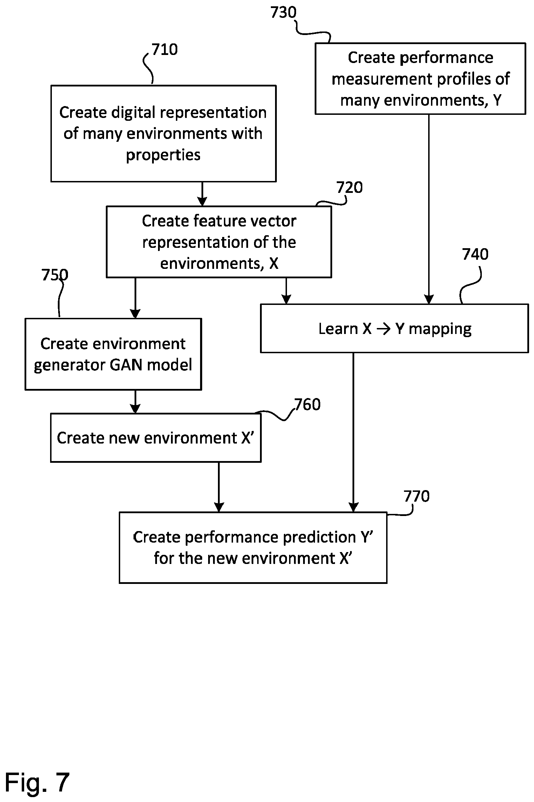

An example of the overall workflow with new environment generation is shown as a flowchart in Figure 7. The workflow comprises the steps being discussed with reference to Figures 3 - 6. Therefore, the workflow, according to the example of Figure 7, comprises
- creating digital representation of many environments with a set of properties 710;
- creating feature vector representations of the environments 720;
- creating performance measurement profiles for many environments 730;
- learning mapping between feature vector representations and performance measurement profiles 740;
- creating an environment generator GAN model 750;
- creating a new environment 760;
- creating a performance prediction for the new environment 770.

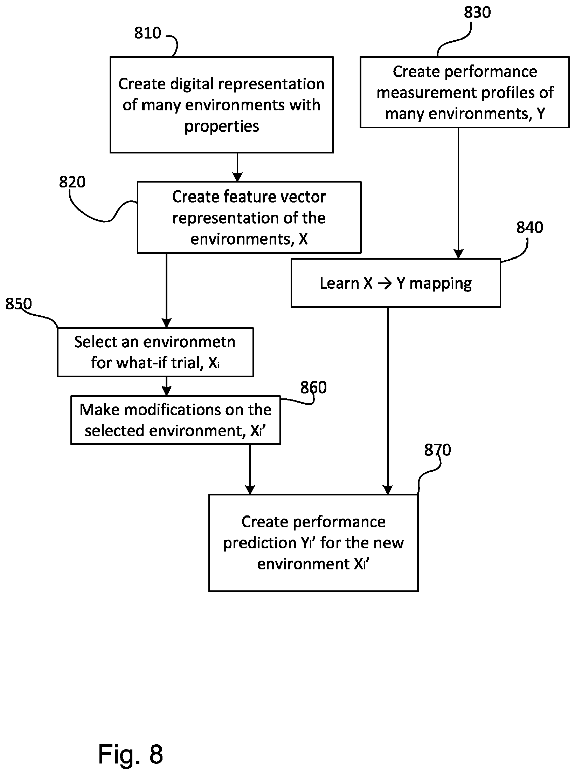

Besides generating new, experimental environments to observe network performance changes, the GNPP also allows what-if experimental trial for observing effects of small modifications in the environment on the network performance profile. This type of workflow is shown as an example in Figure 8.

The workflow according to the example of Figure 8 comprises:
- creating digital representation of many environments with properties 810;
- creating feature vector representation of the environments 820:
- creating performance measurement profiles of many environments 830;
- learning mapping between the feature vector representation and performance measurement profiles 840;
- selecting an environment for what-if trial 850;
- make modifications on the selected environment 860;
- creating performance prediction for the new environment 870.

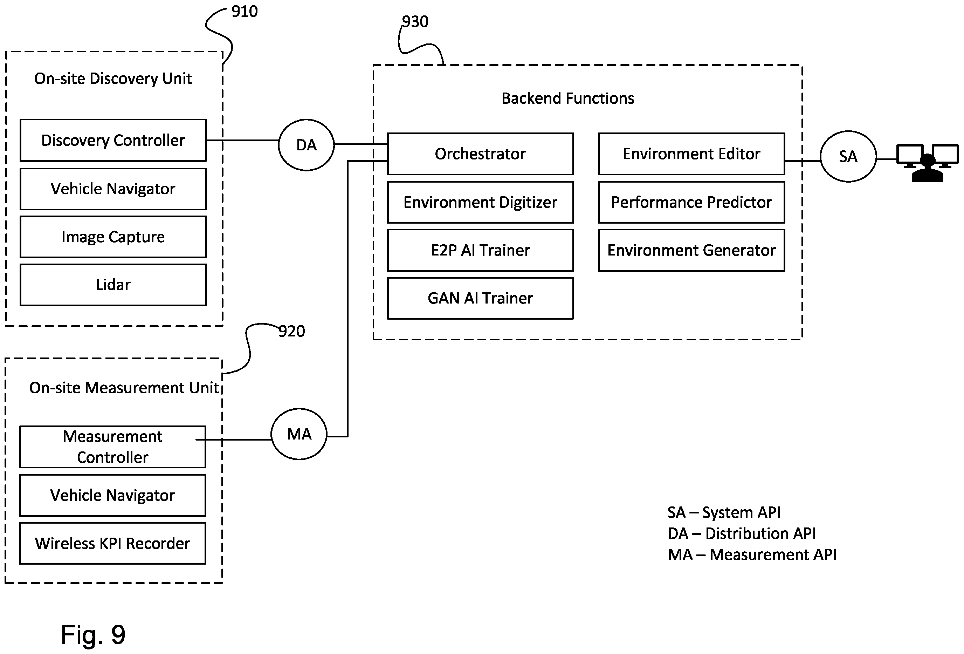

Figure 9 illustrates an example of an implementation of the present embodiments as system level functional components an interconnecting APIs.

The implementation described here shows an embodiment of the solution based on the state-of-the-art distributed software implementation techniques. In terms of locality, the system, according to the example shown in Figure 9, may have three groups of functional components. Each of the components are described with a configuration that should be considered as an example:
1) On-site Discovery Unit 910: This unit is composed of a set of functions that are embedded on a mobile device that resides at a target industrial environment. The purpose of the functions is to scan the environment to create a digital representation. The mobile unit housing the functions may be an autonomous vehicle with compute platform that can navigate at the floor of the industrial environment, a drone flying around the complex, or it may be another type of vehicle that can navigate each section of the industrial environment.
2) On-site Measurement Unit 920: This unit is composed of a set of functions that are also embedded on a mobile device that resides at the target industrial environment. The purpose of the functions is to take wireless network measurement across the target environment. Similarly, the mobile unit housing the functions may be an autonomous vehicle with compute platform that can navigate at the floor of the industrial environment, a drone flying around the complex, or it may be another type of vehicle that can navigate each section of the industrial environment.
3) Backend functions 930: there are group of functions that may be embedded at any cloud computing platform. These group of functions comprises the main Orchestrator, Environment Digitizer, AI Trainers, and AI Predictors

Each of the functions of the system may be implemented as microservices in the form of containers. All the containers may be instantiated and deployed under one or more clusters; for example, Kubernetes platform may be used for this purpose. The On-site Discovery Unit 910 and the On-site Measurement Unit 920 may have "node" affinities within the cluster platform. The functions of these units may then have affinity to the respective nodes. Through this declaration of node affinity, Kubernetes-type platforms can automatically deploy the functions of the intended locality. Instantiation and deployment of the Backend Functions 930 do not need to have node affinity. They can reside on any cloud platform within the Kubernetes type clusters.

The On-site Discovery Unit 910 may have four functions. The discovery controller is the function that coordinates the operation on the On-site Discovery Unit. The Vehicle Navigator is the function that controls the mobility of the unit. The Image Capture function is responsible for collection of photographic images or video recordings of the target environment. The Lidar function is responsible for the other scanning capabilities of the environment.

The On-site Measurement Unit 920 may have three functions. The Measurement Controller function coordinates the operation on the unit. The Vehicle Navigator controls the mobility of the unit. The Wireless KPI Recorder is responsible for taking performance measurements of the wireless network that is in operation. This unit is not covered as part this disclosure; its functions correspond to capabilities that have been referred in earlier sections as F5GT.

There may be seven Backend Functions 930. The Orchestrator is responsible for coordinating the workflow across the whole system. It is connected to the Discovery Controller through the Distribution API (DA). It is connected to the Measurement Controller though the Measurement API (MA). The Orchestrator provides an external interface to the system via the System API (SA). The Environment Digitizer function is responsible for converting the physical environment to a digital representation. The E2P (Environment 2 Performance) AI Trainer function provides DNN (Deep Neural Network) capabilities to learn the mapping between the environment properties and the wireless network performance. The GAN AI Trainer function creates DNN models that are used to create new environments. The Performance Predictor function generates new performance predictions for a given environment. The Environment Generator function uses the DNN model created by the GAN AI Trainer to create new environments. The Environment Editor function allow modifying digital representation of industrial environments, such as moving a machine to the side by 10 meters to see its effect on wireless network performance.

Besides the functions described above, the system implementation may have many other common service functions, such as data repositories, message communication brokers, and many other life-cycle management functions. These functions are not show, since they are not specific to the context of the present embodiments.

An example workflow of the system operation can be as follows:
- A system operator instructs the Orchestrator, through the SA, to start a new discovery session;
- The Orchestrator initiates deployment of the On-site Discovery Unit 910;
- The Orchestrator instructs, through the DA, the Discovery Controller to start the discovery session;
- The Discovery controller provides a high-level operational plan to the Vehicle Navigator based on the characteristics of the environment. The high-level operational pan may also be passed in from the system operator via the Orchestrator;
- The Vehicle Navigator autonomously moves the On-site Discovery Unit 910 across to target environment to cover it from every angle.
- While the unit is moving, the Image capture functions and the Lidar function take recordings an send them to the Discovery Controller;
- At the end of the session, the Discovery Controller passes on all of the recorded data to the Orchestrator.

Similarly,
- The Orchestrator instructs the Measurement Controller via the MA to start a new measurement session;
- The Measurement Controller passes on a high-level plan to the Vehicle Navigator;
- The Vehicle Navigator moves the unit autonomously across the target environment while the Wireless KPI Recorder takes network measurements at all necessary locations;
- The Wireless KPI Recorder passes the recorded data to the Measurement Controller;
- Then, at the end of the measurement session, the Measurement Controller passes all the measurement data to the Orchestrator.
- The Orchestrator passes the discovered environment data to the Environment Digitizer;
- The Environment Digitizer converts the recordings of the physical environment to a digital representation and passes the data of the digital representation back to the Orchestrator;
- The Orchestrator passes the digital representation and the network measurement data to the E2P AI trainer;
- The E2P AI Trainer creates a DNN model by associating the environment data and the measurement data;
- The E2P AI Trainer passes the created DNN model back to the Orchestrator.

The system of Figure 9 is an example of a system to be used to create digital representation of many industrial environments. The Orchestrator passes the collection of all these digital representations to the GAN AI Trainer. Using all these environment samples, the GAN AI trainer may create a DNN model that can be used to create new environments and passes it back to the Orchestrator.

The system operator may use the system to create new network performance predictions for new environments. The system operator may instruct the Orchestrator to create a new environment. The Orchestrator may pass the DNN model created by the GAN AI Trainer to the Environment Generator and may instruct it to create a new environment. The Environment Generator may pass the new environment data back to the Orchestrator. The Orchestrator may pass the DNN model created by the E2P AI Trainer and the new environment data to the Performance Predictor. The Performance predictor may generate wireless network performance prediction for the new environment. The prediction can be send to the system operator.

The system may also be used to see the network performance effect of modifying an environment. The system operator may instruct the Orchestrator to start an editing session. The system operator may select a previously stored environment. The Orchestrator may load the environment representation to the Environment Editor function. Using the Environment Editor, the system operator may modify the environment representation - for example, it moves one of the machines to another position. The model created by the E2P AI Trainer and the new environment data may be passed to the Performance Predictor. The Performance Predictor may generate wireless network performance prediction for the new environment. The prediction can be sent to the system operator.

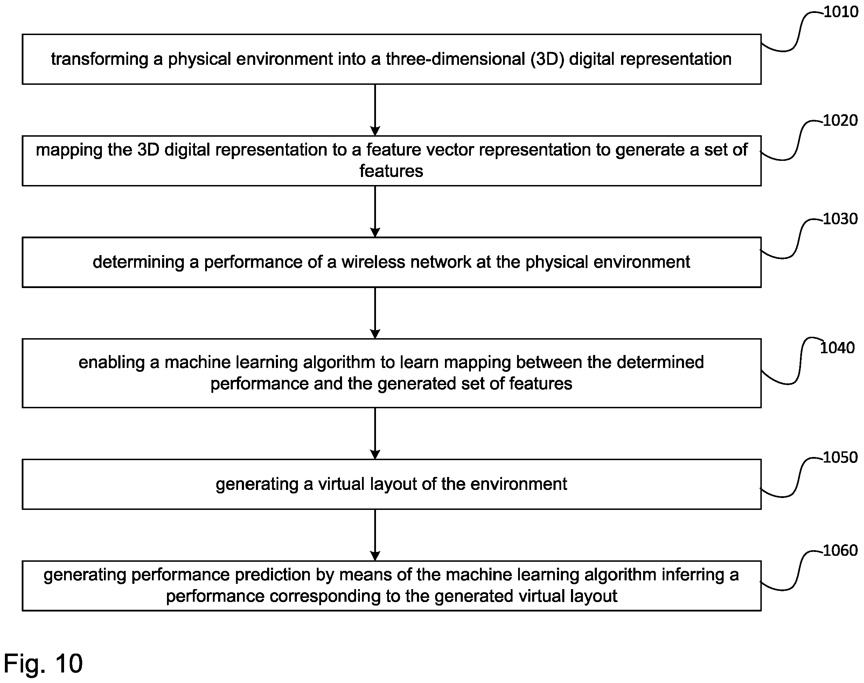

The method according to an embodiment is shown in Figure 10. The method generally comprises transforming 1010 a physical environment into a three-dimensional (3D) digital representation; mapping 1020 the 3D digital representation to a feature vector representation to generate a set of features; determining 1030 a performance of a wireless network at the physical environment; enabling 1040 a machine learning algorithm to learn mapping between the determined performance and the generated set of features; generating 1050 a virtual layout of the environment; and generating 1060 performance prediction by means of the machine learning algorithm inferring a performance corresponding to the generated virtual layout. Each of the steps can be implemented by a respective module of a computer system.

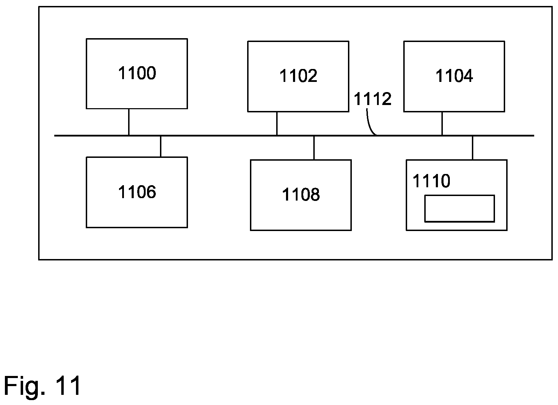

An apparatus according to an embodiment comprises means for transforming a physical environment into a three-dimensional (3D) digital representation; means for mapping the 3D digital representation to a feature vector representation to generate a set of features; means for determining a performance of a wireless network at the physical environment; means for enabling a machine learning algorithm to learn mapping between the determined performance and the generated set of features; means for generating a virtual layout of the environment; and means for generating performance prediction by means of the machine learning algorithm inferring a performance corresponding to the generated virtual layout. The means comprises at least one processor, and a memory including a computer program code, wherein the processor may further comprise processor circuitry. The memory and the computer program code are configured to, with the at least one processor, cause the apparatus to perform the method of Figure 11 according to various embodiments.

Figure 11 illustrates an apparatus according to an embodiment. The generalized structure of the apparatus will be explained in accordance with the functional blocks of the system. Several functionalities can be carried out with a single physical device, e.g. all calculation procedures can be performed in a single processor if desired. A data processing system of an apparatus according to an example of Figure 11 comprises a main processing unit 1100, a memory 1102, a storage device 1104, an input device 1106, an output device 1108, and a graphics subsystem 1110, which are all connected to each other via a data bus 1112. A client may be understood as a client device or a software client running on an apparatus.

The main processing unit 1100 is a processing unit arranged to process data within the data processing system. The main processing unit 1100 may comprise or be implemented as one or more processors or processor circuitry. The memory 1102, the storage device 1104, the input device 1106, and the output device 1108 may include other components as recognized by those skilled in the art. The memory 1102 and storage device 1104 store data in the data processing system 1100. Computer program code resides in the memory 1102 for implementing, for example, machine learning process. The input device 1106 inputs data into the system while the output device 1108 receives data from the data processing system and forwards the data, for example to a display. While data bus 1112 is shown as a single line it may be any combination of the following: a processor bus, a PCI bus, a graphical bus, an ISA bus. Accordingly, a skilled person readily recognizes that the apparatus may be any data processing device, such as a computer device, a personal computer, a server computer, a mobile phone, a smart phone or an Internet access device, for example Internet tablet computer.

The various embodiments can be implemented with the help of computer program code that resides in a memory and causes the relevant apparatuses to carry out the method. For example, a device may comprise circuitry and electronics for handling, receiving and transmitting data, computer program code in a memory, and a processor that, when running the computer program code, causes the device to carry out the features of an embodiment. Yet further, a network device like a server may comprise circuitry and electronics for handling, receiving and transmitting data, computer program code in a memory, and a processor that, when running the computer program code, causes the network device to carry out the features of various embodiments.

If desired, the different functions discussed herein may be performed in a different order and/or concurrently with other. Furthermore, if desired, one or more of the above-described functions and embodiments may be optional or may be combined.

Although various aspects of the embodiments are set out in the independent claims, other aspects comprise other combinations of features from the described embodiments and/or the dependent claims with the features of the independent claims, and not solely the combinations explicitly set out in the claims.

It is also noted herein that while the above describes example embodiments, these descriptions should not be viewed in a limiting sense. Rather, there are several variations and modifications, which may be made without departing from the scope of the present disclosure as, defined in the appended claims.

## Claims

1. An apparatus, comprising
- means for transforming a physical environment into a three-dimensional (3D) digital representation;
- means for mapping the 3D digital representation to a feature vector representation to generate a set of features;
- means for determining a performance of a wireless network at the physical environment;
- means for enabling a machine learning algorithm to learn mapping between the determined performance and the generated set of features;
- means for generating a virtual layout of the environment; and
- means for generating performance prediction by means of the machine learning algorithm inferring a performance corresponding to the generated virtual layout.

2. The apparatus according to claim 1, further comprising means for processing the 3D digital representation to identify objects at desired level of granularity, wherein the objects are used to generate a set of features.

3. The apparatus according to claim 1 or 2, wherein the virtual industrial layout is generated by using Generative Adversarial Network.

4. The apparatus according to claim 1 or 2 or 3, further comprising means for capturing physical properties of the physical environment, based on which the transformation into the digital representation is performed.

5. The apparatus according to claim 4, further comprising means for performing object recognition on captured physical properties.

6. The apparatus according to any of the claims 1 to 5, wherein the physical environment is an industrial environment.

7. A method, comprising
- transforming a physical environment into a three-dimensional (3D) digital representation;
- mapping the 3D digital representation to a feature vector representation to generate a set of features;
- determining a performance of a wireless network at a physical environment;
- enabling a machine learning algorithm to learn mapping between the determined performance and the generated set of features;
- generating a virtual layout of the environment; and
- generating performance prediction by means of the machine learning algorithm inferring a performance corresponding to the generated virtual layout.

8. The apparatus according to claim 7, further comprising processing the 3D digital representation to identify objects at desired level of granularity, wherein the objects are used to generate a set of features.

9. The method according to claim 7 or 8, wherein the virtual industrial layout is generated by using Generative Adversarial Network.

10. The method according to claim 7 or 8 or 9, further comprising capturing physical properties of the physical environment, based on which the transformation into the digital representation is performed.

11. The method according to claim 10, further comprising performing object recognition on captured physical properties.

12. The method according to any of the claims 7 to 11, wherein the physical environment is an industrial environment.

13. An apparatus comprising at least one processor, memory including computer program code, the memory and the computer program code configured to, with the at least one processor, cause the apparatus to perform at least the following:
- transform a physical environment into a three-dimensional (3D) digital representation;
- map the 3D digital representation to a feature vector representation to generate a set of features;
- determine a performance of a wireless network at a physical environment;
- enable a machine learning algorithm to learn mapping between the determined performance and the generated set of features;
- generate a virtual layout of the environment; and
- generate performance prediction by means of the machine learning algorithm inferring a performance corresponding to the generated virtual layout.
